# EUROPEAN PATENT SPECIFICATION

(11) **EP 0 204 963 B1**
(45) Date of publication and mention of the grant of the patent: **13.01.1993**
(21) Application number: 86106238.8
(22) Date of filing: 07.05.1986
(51) Int. Cl.: C08G 77/14, G03F 7/004

(54) **Use of Alkali-Soluble Polyorganosilsesquioxane Polymers in a resist for preparing electronics parts.**
Verwendung von in alkalische Milieu löslichen Silsesquioxanpolymeren in einem Resist zur Herstellung von electronischen Teilen
Utilisation des Polymères de silsesquioxanes solubles dans un milieu alcalin dans un résiste pour la préparation des composants électroniques.

(30) Priority: 10.05.1985 JP 98032/85; 22.08.1985 JP 182950/85; 24.10.1985 JP 236344/85
(43) Date of publication of application: 17.12.1986
(73) Proprietor: HITACHI, LTD., Chiyoda-ku, Tokyo 100 (JP)
(72) Inventor: Sugiyama, Hisashi, Totsuka-ku Yokohama-shi (JP); Nate, Kazuo, Totsuka-ku Yokohama-shi (JP); Inoue, Takashi, Totsuka-ku Yokohama-shi (JP); Mizushima, Akiko, Yokohama-shi Kanagawa-ken (JP)
(74) Representative: Dost, Wolfgang, Dr. rer.nat., Dipl.-Chem.

(56) References cited:
- EP-A- 0 049 127
- EP-A- 0 147 127
- GB-A- 1 022 742
- GB-A- 1 203 071
- US-A- 3 579 467
- PATENT ABSTRACTS OF JAPAN, vol. 9, no. 224 (P-387)[1947], 10th September 1985; & JP-A-60 80 844 (NIPPON DENSHIN DENWA KOSHA) 08-05-1985

## Description

### BACKGROUND OF THE INVENTION

The present invention relates to a new polymer which is extremely useful as a functional polymeric material such as light-sensitive and radiation-sensitive materials.

Electronic parts such as semiconductor devices and integrated circuits are produced by means of microetching with light or radiation. Etching requires a resist, and the resist of alkali-development type is predominant because of its high resolution. It contains as a basic polymer an alkali-soluble polymer such as phenolic resin and polyvinyl phenol. For example, a composition of phenol novolak resin and o-quinonediazide forms a positive photoresist, and a composition of polyvinyl phenol and bisazide forms a negative photoresist.

After patterning of the resist layer, the exposed substrate undergoes etching. In view of the trend to ever smaller circuit patterns of semiconductor devices, wet etching is being replaced by dry etching. Thus, a resist material is required to withstand dry etching. In the case where the substrate is an organic material, etching is carried out by an oxygen plasma. The conventional resist material is poor in resistance to oxygen plasmas, and there is a demand for the improvement in this regard.

The resist of alkali-development type is described in "Kodak Microelectronics Seminor Proceedings, 116 (1976), by J. C. Strieter.

### SUMMARY OF THE INVENTION

It is an object of the present invention to provide an alkali-soluble silsesquioxane polymer which is superior in resistance to oxygen plasmas.

The present inventors synthesized a variety of polymers in which the main chain is a silsesquioxane skeleton and the side chain has phenolic hydroxyl groups. As the result, it was found that the above-mentioned object is achieved by a GB-A-1 022 742 discloses, i.a., a compound of the formula 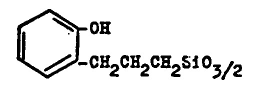
wherein the OH is in ortho or para position. It is stated therein that the compounds of the invention are useful as softeners in phenolic varnishes and coating resins to give improved flexibility. They are also useful as finishing agents on siliceous materials such as glass, glass cloth, silica and sand, or such end uses as moulding compounds, laminates such as polyester and phenolic laminates, shell mouldings, and for purposes of sand consolidation. They are also valuable as curing agents and accelerators for epoxy resins polymer in which the main chain is polysilsesquioxane having a structure very close to that of silicon oxide, and the side chain has phenolic hydroxyl groups. As the result, it was found that the above-mentioned object is achieved by a polyorganosilsesquioxane represented by the following formula (1) 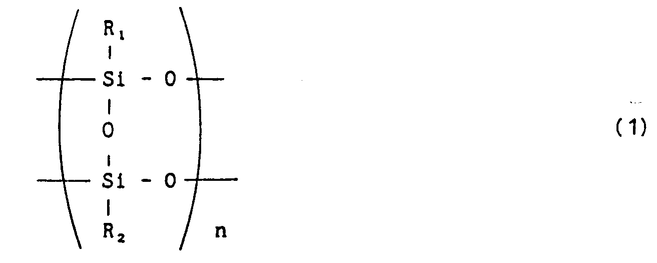
wherein R₁ and R₂ are the same or different and selected from phenolic hydroxyl groups -containing substituents of the group 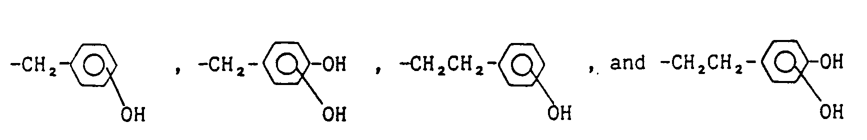
or from said substituents in which the phenolic hydroxyl groups are substituted by alkoxy groups, t-butyl-dimethylsiloxy groups, or methylene acetal groups, and n is the degree of polymerization, with the proviso that more than 40% of the side chains R₁ and R₂ have phenolic hydroxyl groups.

The polymer (1) of this invention is produced in two steps. In the first step, a polyorganosilsesquioxane, with the hydroxyl group protected, is synthesized from a corresponding trichlorosilane or trialkoxysilane. In the second step, the protective group is removed. The trichlorosilane or trialkoxysilane may be produced in many ways. Examples include the Grignard reaction, the condensation of a halide (such as benzyl chloride derivative) and HSiCl₃ by the aid of a tertiary amine and copper salt, and the addition of HSiCl₃ to a styrene derivative by the aid of a platinum catalyst.

The polyorganosilsesquioxane with the hydroxyl group protected was synthesized according to the processes, with or without modification, disclosed in J. Am. Chem. Soc., 82, 6194 (1960), J. Am. Chem. Soc., 87, 4317 (1965), Japanese Patent Publication No. 15989/1965, and Japanese Patent Laid-open Nos. 88099/1978 and 66422/1984. The resulting polymers had a degree of polymerization (n) in the range of 8 to 200 regardless of the process. Therefore, the process for synthesis is not specifically limited in this invention. On the other hand, there are various methods for removing the protective group. For example, trimethylsilyl iodide is used for an alkoxy group; tetra-n-butylammonium fluoride is used for a t-butyldimethylsiloxy group; and phosphorus pentachloride is used for methylene acetal. All of these methods can be applied to the synthesis of the polymer of this invention. Therefore, there are no limits in the methods of removing the protective group in the synthesis of the polymer of this invention.

The polymer of this invention is soluble in alkaline water such as aqueous solutions of tetramethylammonium hydroxide and potassium hydroxide; and it is also readily soluble in widely used organic solvents such as alcohols, ethers, amides, ketones, esters, and cellosolves®. Thus, the polymer can be made into film by the aid of one of these solvents.

The polymer of this invention can be used as a base material of photoresists for light or radiation, if it is incorporated with a photo-sensitive or radiation-sensitive dissolution inhibitor suitable for the light or radiation to be used. The thus produced photoresist can be developed with an alkali.

In addition, as in the case of conventional resist of alkali development type, the polymer of this invention can be used as a positive photoresist if it is combined with o-quinonediazide, and it can also be used as a negative photoresist if it is combined with bisazide. The polymer of this invention as such can be used as a negative electron resist. On the other hand, when combined with poly(olefinsulfone), it can be used as a positive electron resist.

The film formed from the polymer of this invention does not waste at all in an oxygen plasma, keeping an extremely high resistance to dry etching. Therefore, it can be used as the top layer resist where the double-layer resist method is employed.

### DESCRIPTION OF THE PREFERRED EMBODIMENTS

The invention is now described in more detail with reference to the following example.

### EXAMPLE

Poly(hydroxybenzylsilsesquioxane-co-p-methoxybenzylsilsesquioxane):

### (a) Synthesis of p-methoxybenzyltrichlorosilane

In a 2-liter three-neck flask equipped with a stirrer, reflux condenser, dropping funnel, and thermometer were placed 30 g (1.2 gram atom) of magnesium powder, 170 g (1.00 mol) of silicon tetrachloride, and 500 ml of diethyl ether. The flask was cooled below 10°C. A mixture of 100.0 g (0.639 mol) of p-methoxybenzyl chloride and 200 ml of diethyl ether was added dropwise with stirring from the dropping funnel over 4 hours. After aging at room temperature for 1 hour, excess magnesium and magnesium chloride were removed by suction filtration. The filtrate was distilled to give 44.0 g (0.172 mol) of the desired product in a yield of 26.9%.

The properties of the desired product were as follows:
Boiling point: 117.5 - 119.5°C/3.0 mmHg
NMR : (60 MHz, CCl₄, CH₂Cl₂, δ 5.33) δ 2.91 (2H, s), δ 3.90 (3H, s), δ 6.91 (2H, d, J=8 Hz), δ 7.20 (2H, d, J=8 Hz).

### (b) Synthesis of poly(p-methoxybenzylsilsesquioxane)

In a 100-ml three-neck flask equipped with a magnetic bar, dropping funnel, and reflux condenser were placed 11 g (0.13 mol) of sodium hydrogen carbonate and 40 ml of water. A mixture of 10.23 g (40.00 mmol) of p-methoxybenzyltrichlorosilane and 10 mi of diethyl ether was added dropwise from the dropping funnel over 30 minutes, followed by aging for 30 minutes. After the completion of the reaction, the reaction mixture was extracted with ether, and the extract was dried with sodium sulfate. Diethyl ether was distilled away under reduced pressure to give 5.10 g of hydrolyzate.

The properties of the hydrolyzate were as follows:
NMR : (60 MHz, CDCl₃, CH₂Cl₂, δ 5.33) δ 2.03 (2H, br. s), δ 3.80 (3H, br. s), δ 6.80 (4H, br. s).
IR (ν cm⁻¹) 3400, 2950, 2850, 1610, 1510, 1460, 1300, 1250, 1180, 1090, 1035, 890, 835, 790, 760.
Weight-average molecular weight: 2,000
In a 25-ml eggplant-shape flask were placed 4.80 g of the hydrolyzate obtained as mentioned above and 49 mg of 10 wt% solution of potassium hydroxide in methanol. The contents were heated at 200°C for 2 hours. After the completion of the reaction, the reaction mixture was dissolved in benzene and the benzene solution was added dropwise to methanol to precipitate solids. The solids were filtered off and dried to give 4.00 g of poly(p-methoxybenzylsilsesquioxane).
NMR : (60 MHz, CDCl₃, CH₂Cl₂, δ 5.33) δ 1.19 (2H, br. s), δ 3.78 (3H, br. s), δ 6.73 (4H, br. s).
IR (ν cm⁻¹) 2950, 2850, 1615, 1515, 1465, 1305, 1250, 1195, 1120, 1040, 840, 800, 770.
Weight-average molecular weight: 3,300

### (c) Synthesis of poly(hydroxybenzylsilsesquioxane-co-p-methoxybenzylsilsesquioxane):

In a 100-ml eggplant-shape flask equipped with a reflux condenser were placed 3.73 g of the polymer from (b) (21.6 mmol in terms of MeOC₆H₅CH₂SiO_{3/2}), 20 ml of chloroform, and 6.92 g (34.6 mmol) of trimethylsilyl iodide. Reaction was carried out at 70°C for 22 hours with stirring by a magnetic bar. 20 ml of methanol was added at room temperature and stirring was continued for 30 minutes. Low boiling fractions were distilled away under reduced pressure, and the residues were extracted with a mixed solvent of diethyl ether and tetrahydrofuran. The extract was washed with an aqueous solution of sodium hydrogen sulfite, an aqueous solution of sodium hydrogen carbonate, and finally an aqueous solution of sodium chloride. The solvent was distilled away under reduced pressure. The resulting polymer was reprecipitated from acetone/hexane. After thermodrying under reduced pressure, there was obtained 2.71 g of the desired product.

The properties of the desired product were as follows:
Weight-average molecular weight: 4,800
Conversion of methoxy to OH : 85%
NMR : (60 MHz, DMSO-d₆, δ 5.68) δ 1.75 (2H, br. s), 3.63 (-OCH₃, br. s), 6.58 (4H, br. s), 8.88 (-OH, br. s).
IR (ν cm⁻¹) 3350, 1620, 1515, 1450, 1240, 1185, 1120, 1040, 840, 805, 760.

In the meantime, the OH content can be controlled by the amount of trimethylsilyl iodide or the reaction time. For example, where 1.6 equivalent of trimethylsilyl iodide was used, the reaction time of 4 hours brought about a 36% conversion of methoxy groups into hydroxyl groups, 7 hours, 54%, 12 hours, 75%, 48 hours, 95%, and 72 hours, almost 100%. The OH content was determined by performing the reaction in deuterochloroform. During the reaction, the conversion of methoxy groups into trimethylsiloxy groups was traced by means of NMR spectrometry.

### (d) Solubility

Polymer of this invention was examined for solubility toward commonly used organic solvents. The polymer having more than 50% of hydroxyl groups were soluble in methanol, tetrahydrofuran, N,N-dimethylacetamide, 2-methylcyclohexanone, isoamyl acetate, ethyl cellosolve® (ethoxyethanol), and dimethylsulfoxide, and were insoluble in toluene, hexane, and carbon tetrachloride.

It was also soluble in an aqueous solution of tetramethyl ammonium hydroxide.

### (e) Resistance to oxygen plasmas

An 8 wt% solution of the polymer of this invention in 2-methylcyclohexanone was applied to a silicon substrate by spin coating method. Upon baking at 100°C for 30 minutes, there was obtained a 0.2 µm thick film. The baked film was exposed to oxygen plasmas (oxygen pressure: 67 Pa (0.5 Torr), RF: 300 W, barrel type asher) for 20 minutes. The film did not waste at all.

## Claims

1. The use of a polyorganosilsesquioxane represented by the formula 1 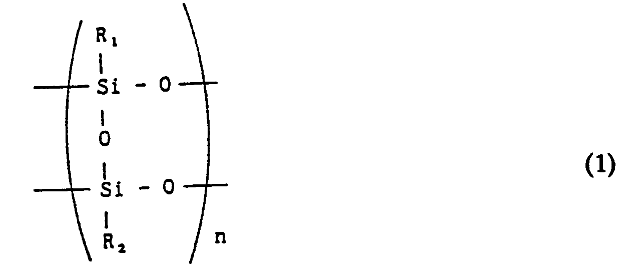 wherein R₁ and R₂ are the same or different and selected from substituents of the formulas 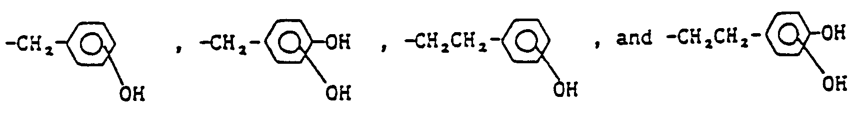 and substituents of said formulas in which the phenolic hydroxyl groups are substituted by alkoxy, t-butyl-dimethylsiloxy or methylene acetal groups, and n is the degree of polymerization, with the proviso that more than 40 % of the side chains R₁ and R₂ have phenolic hydroxyl groups, as a basic polymer in a resist for preparing electronic parts, such as semiconductor devices and integrated circuits, by microetching with light or radiation.

2. The use of claim 1, wherein R₁ and R₂ are selected from p-hydroxybenzyl and p-methoxybenzyl groups, and n is from 8 to 200.

## Patentansprüche

1. Verwendung eines Polyorganosilsesquioxans, dargestellt durch die folgende Formel (1): 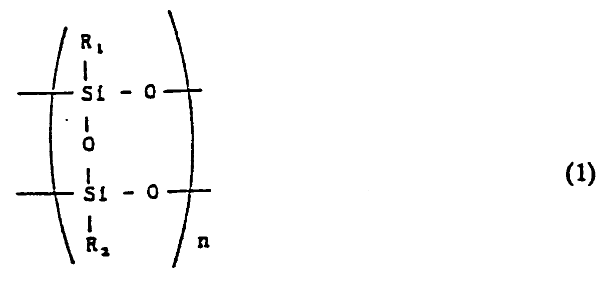 worin R₁ und R₂ gleich oder verschieden sind und aus den Substituenten der Formeln 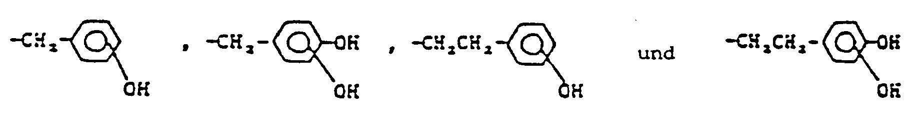 und solchen Substituenten dieser Formeln ausgewählt sind, in denen die phenolischen Hydroxylgruppen durch Alkoxy-, tert.-Butyldimethylsiloxy- oder Methylenacetalgruppen substituiert sind, und worin n der Polymerisationsgrad ist, mit der Maßgabe, daß mehr als 40 % der Seitenketten R₁ und R₂ phenolische Hydroxylgruppen aufweisen, als polymerer Hauptbestandteil in einem Resist zur Herstellung elektronischer Bauelemente, wie Halbleiter-Vorrichtungen und integrierte Schaltkreise, durch Mikroätzen mit Licht oder Strahlung.

2. Verwendung gemäß Anspruch 1, wobei R₁ und R₂ aus p-Hydroxybenzyl- und p-Methoxybenzylgruppen ausgewählt sind und n einen Wert von 8 bis 200 besitzt.

## Revendications

1. L'utilisation d'un polyorganosilsesquioxane représenté par la formule 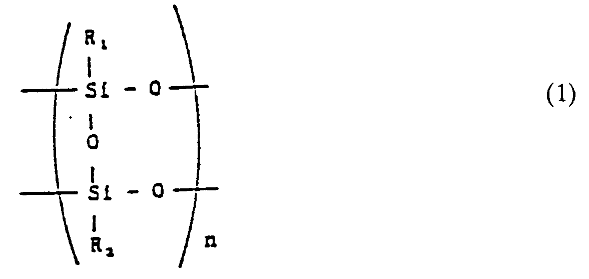 où R₁ et R₂ sont identiques ou différents et choisis parmi les substituants de formules 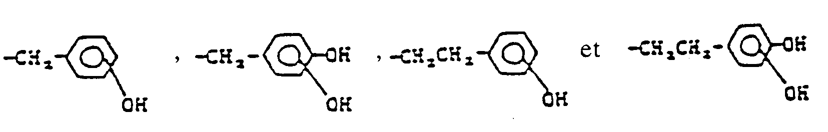 et les substituants de ces formules dans lesquels les groupes hydroxyle phénoliques sont substitués par des groupes alkoxy, t-butyl-diméthylsiloxy ou acétal-méthyléniques, et n est le degré de polymérisation, étant entendu que plus de 40 % des chaînes latérales R₁ et R₂ possèdent des groupes hydroxyle phénoliques,
comme polymère de base d'une résine photorésistante pour la préparation d'éléments électroniques, tels que des composants semi-conducteurs et des circuits intégrés, par microgravure à la lumière ou à une radiation.

2. L'utilisation selon la revendication 1, où R₁ et R₂ sont choisis parmi les groupes p-hydroxybenzyle et p-méthoxybenzyle, et n est compris entre 8 et 200.
